# EUROPEAN PATENT APPLICATION

(11) **EP 1 431 241 A2**
(43) Date of publication of application: **23.06.2004**
(21) Application number: 03104568.5
(22) Date of filing: 05.12.2003
(51) Int. Cl.: B81B 3/00, G12B 21/02, G01R 3/00, G01R 1/073

(54) **Probe finger structure and method for making a probe finger structure**

(30) Priority: 20.12.2002 US 325409
(71) Applicant: ROSEMOUNT AEROSPACE INC., Burnsville, MN 55306 (US)
(72) Inventor: Koch, Daniel, J, 55044, Lakeville (US); Keenan, David, R, 55057, Northfield (US); Gephart, Greg, L, 55044, Lakeville (US)
(74) Representative: Asquith, Julian Peter

(57) **Abstract**

A method for making a probe finger structure (14) including the steps of providing a wafer or wafer portion having an upper layer (32), a lower layer (30) and an insulating or etch stop layer (34) located between the upper and lower layers. The method further includes the step of etching the lower layer to form a mounting portion, and etching the upper layer to form a plurality of probe fingers. The method also includes the step of locating an electrically conductive material (40) on each of the probe fingers.

## Description

The present invention is directed to a probe finger structure and a method for making a probe finger structure which may be used in various testing structures.

### BACKGROUND

Contact structures may be used to test various electrical and electronic components, such as IC chips, semiconductor wafers, semiconductor devices, printed circuit boards, IC leads, memory chips and the like. Contact structures may also be used as chemical sensors, electrical sensors, inertial sensors, DNA screening devices, microactuators, atomic force microscopes ("AFM"), scanning probe microscopes ("SPM") and the like. Such contact structures typically include a plurality of probe fingers shaped and located to engage contact points or contact locations on the component, surface, or fluid to be tested. Due to the small size of some of the components to be tested and the small spacing which may exist between the contact locations, the probe fingers should be accurately located and oriented, and have precisely controlled dimensions. Accordingly, there is a need for an improved probe finger structure and an improved method for making a probe finger structure.

### SUMMARY

In one embodiment, the invention is a method for making a probe structure by machining a semiconductor-on-insulator wafer (such as a silicon-on-insulator wafer) to form the probe structure. The use of a semiconductor-on-insulator wafer may help to provide accurate depth control, precise dimensions and improved electrical isolation of the probe fingers.

In one embodiment the invention is a method for making a probe finger structure including the steps of providing a wafer or wafer portion having an upper layer, a lower layer and an insulating layer or etch stop layer located between the upper and lower layers. The method further includes the step of etching the lower layer to form a mounting portion, and etching the upper layer to form a plurality of probe fingers. The method also includes the step of locating an electrically conductive material on each of the probe fingers. Other objects and advantages of the present invention will be apparent from the following description and the accompanying drawings.

### BRIEF DESCRIPTION OF THE DRAWINGS

Fig. 1 is a schematic view of one embodiment of the probe finger structure of the present invention, mounted to a substrate and shown with a test structure;
Fig. 2 is a perspective view of one embodiment of the probe finger structure of the present invention;
Fig. 3 is a perspective view of another embodiment of the probe finger structure of the present invention, mounted to a substrate;
Fig. 4 is a perspective view of another embodiment of the probe finger structure of the present invention;
Figs. 5-29 are a series of end cross sections, side cross sections and top views illustrating a process used to form one embodiment of the probe finger structure of the present invention; and
Figs. 30-47 are a series of end cross sections and top views illustrating another process used to form one embodiment of the probe finger structure of the present invention.

### DETAILED DESCRIPTION

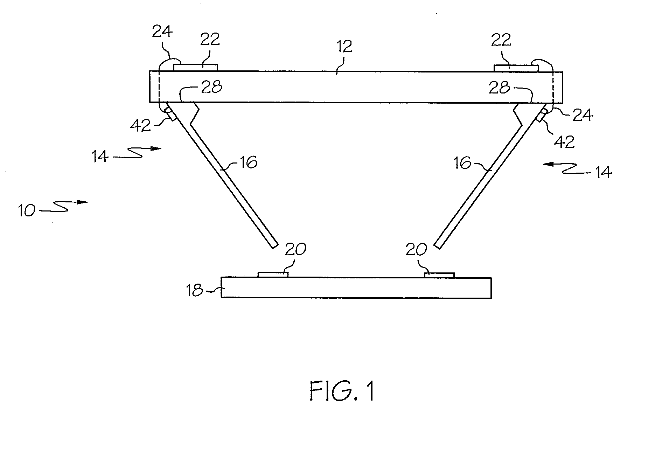

As shown in Fig. 1, a testing structure, generally designated 10, may include a substrate 12 and a probe structure or structures 14. Each probe structure 14 may include a plurality of probe fingers 16 which may extend generally downwardly from the substrate 12 at an acute angle thereof. Each of the probe fingers 16 may be made of or include a conductive material. In one embodiment, the contact structure 10 may be used to test the operation of, or electrical connections of, a test component 18, which can be any of a variety of electrical or electronic components, including but not limited to IC chips, semiconductor wafers, semiconductor devices, printed circuit boards, IC leads, memory chips and the like. The test component 18 may include a plurality of connection points or locations 20, and each probe finger 16 may be shaped and located to contact one of the contact points 20. Each of the probe fingers 16 may be electrically coupled to a contact 22 located on a top surface of the substrate 12 by an associated lead 24 that extends through or around the substrate 12.

When the testing structure 10 is lowered and/or the test component 18 is raised, each probe finger 16 may contact a contact point 20 of the test component 18. Each probe finger 16 may be connected to a processor, controller, CPU or the like (not shown) via the contacts 22 on the substrate 12. In this manner, various electrical signals can be sent between the processor, CPU or controller and the test component 18. For example, the processor can then send test signals to the test component 18 and receive resultant output signals from the test component 18. The received signals can then be compared with the expected or desired results to determine the operating or other characteristics of the examined test component 18. In this manner, the probe structures 14 may be used, for example, to test the component 18 at the end of a manufacturing process as a quality control step.

The test component 18 or other component to be tested may be relatively small such that the contact points 20 may be relatively closely spaced (i.e., may have a spacing as little as about 40 microns or less). Thus, it may be desired that the probe fingers 16 be precisely located and have precise dimensions, and that the manufacturing process for making the probe fingers 16 consistently and repeatedly produce probe fingers 16 having the desired dimensions and characteristics. In one embodiment, each probe finger 16 may be, for example, about 1 mm long, have a width of about 30 microns, and have a height of about 55 microns.

The angled arrangement of the probe fingers 16 may enable each probe finger 16 to flex in a "spring"-like manner when each probe finger 16 contacts the test component 18. In this manner, each probe finger 16 may be able to be vertically shifted to account for any non-planarities in the test component 18 and/or to account for non-uniform lengths or other varying dimensions of the probe fingers 16. The angled orientation of the probe fingers 16 may also enable the tip of each probe finger 16 to "scrub" away any native oxides located on the contact points 20 to ensure good electrical contact between the probe finger 16 and corresponding contact point 20. However, it should be understood that the probe fingers 16 need not necessarily extend from the substrate 12 at an acute angle, and the probe fingers 16 may instead extend, for example, generally perpendicular to the substrate 12. Each probe finger 16 may also have other shapes, configurations and/or dimensions as desired to perform the desired function(s).

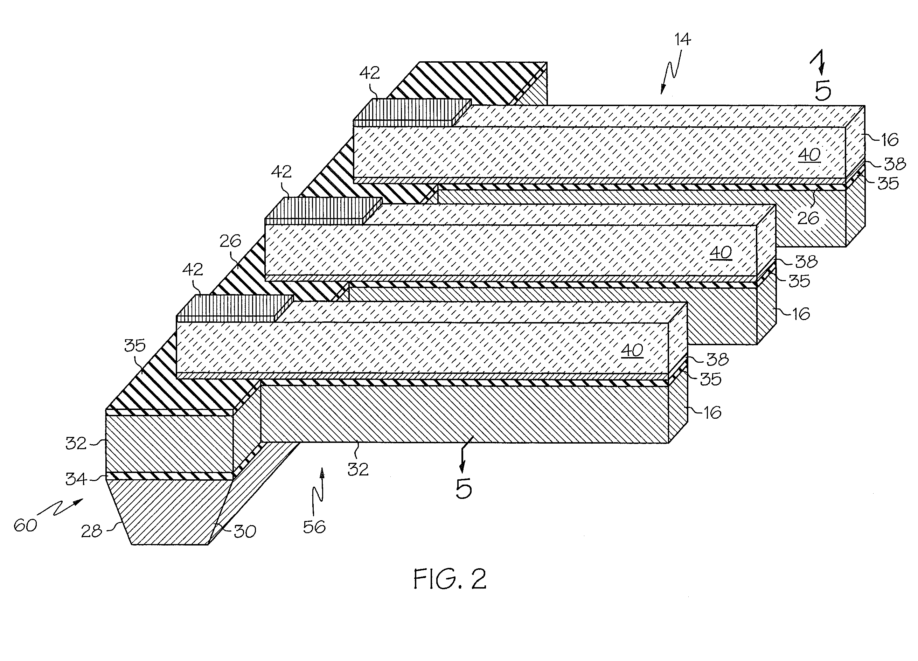

Fig. 2 illustrates the probe structure 14 of Fig. 1 separate from the substrate 12. As can be seen in Fig. 2, the probe structure 14 may include a plurality of probe fingers 16 coupled to a base 26 to form a generally comb-like structure. The base 26 may have a tapered or angled surface 28 which may be coupled to the substrate 12 (see Fig. 1) to enable the probe fingers 16 to extend from the substrate 12 at an angle.

The base 26 may include a lower layer 30 (which can be made of a semiconducting material, such as silicon), an upper layer 32 (which can be made of semiconducting material, such as silicon), and an intermediate insulating or etch stop layer 34 (which can be, for example, silicon dioxide) located between the upper 32 and lower 30 layers. The base 26 may include an upper insulating layer 35 (such as silicon dioxide or silicon nitride) located on its upper surface, and a seed metal, seed material or seed layer 38 (such as Ti/Au) may be located on the upper insulating layer 35 along each probe finger 16. The seed layer 38 may include a layer of conductive material 40 (such as nickel) located thereon, and each portion of conductive material 40 may include a bond pad 42 (such as gold) located thereon at its base. The upper layer 32 may provide mechanical strength to the conductive material 40. The conductive material 40 of each probe finger 16 may be shaped and located to engage the contact points 20 of the test structure 18, and the bond pads 42 may provide a surface to which the leads 24 can be coupled (see Fig. 1).

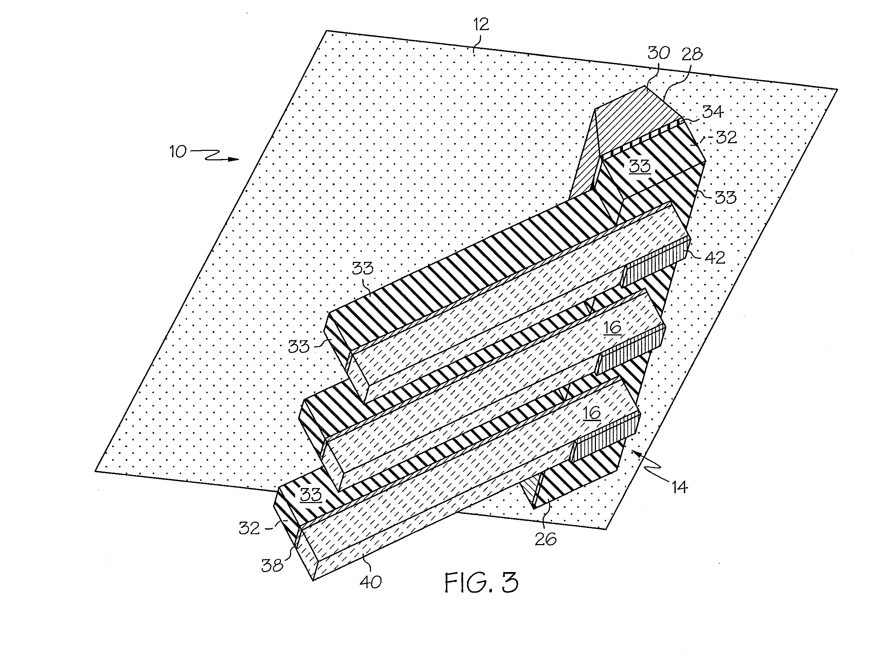

Fig. 3 illustrates another embodiment of the probe finger structure 16 coupled to a substrate 12. However, in the embodiment of Fig. 3, the upper layer 32 (and in particular the portions of the upper layer 32 forming the probe fingers 16) is encapsulated in an insulating layer 33, such as silicon dioxide. As will be discussed below, the insulating layer 33 may help to protect the probe fingers 16 during processing.

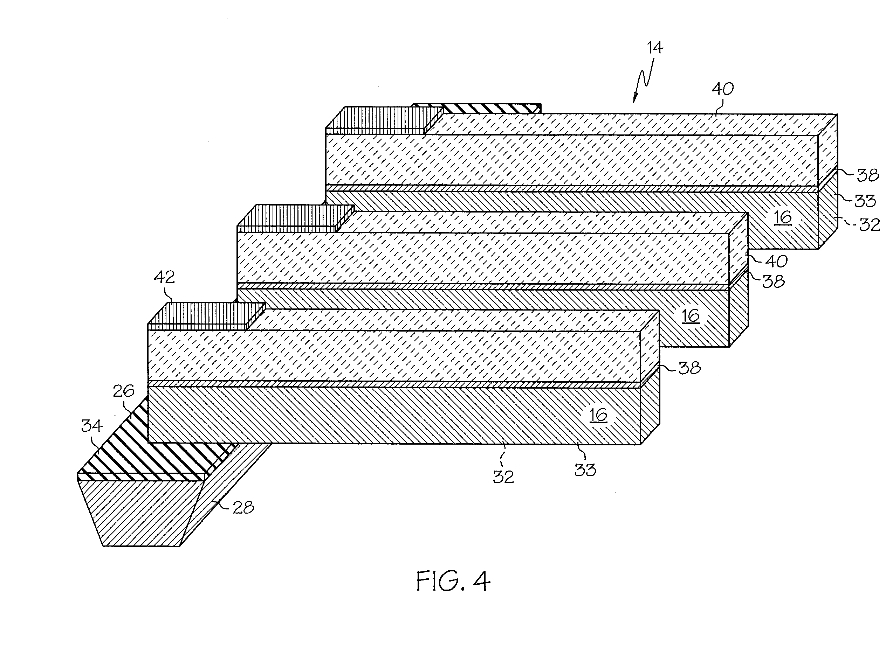

Fig. 4 illustrates an alternate embodiment of the probe finger structure 14 which is similar to that of Figs. 2 and 3, but selected portions of the base 26 (i.e., portions of the upper layer 32 located between the probe fingers 16) are removed. The removal of these portions of the base 26 (in particular, the portions of the upper layer 32) helps to further electrically isolate each of the probe fingers 16 from each other. In the illustrated embodiment, portions of the upper layer 32 of each probe finger 16 are encapsulated in the oxide layer 33 which helps to further electrically isolate each of the probe fingers 16.

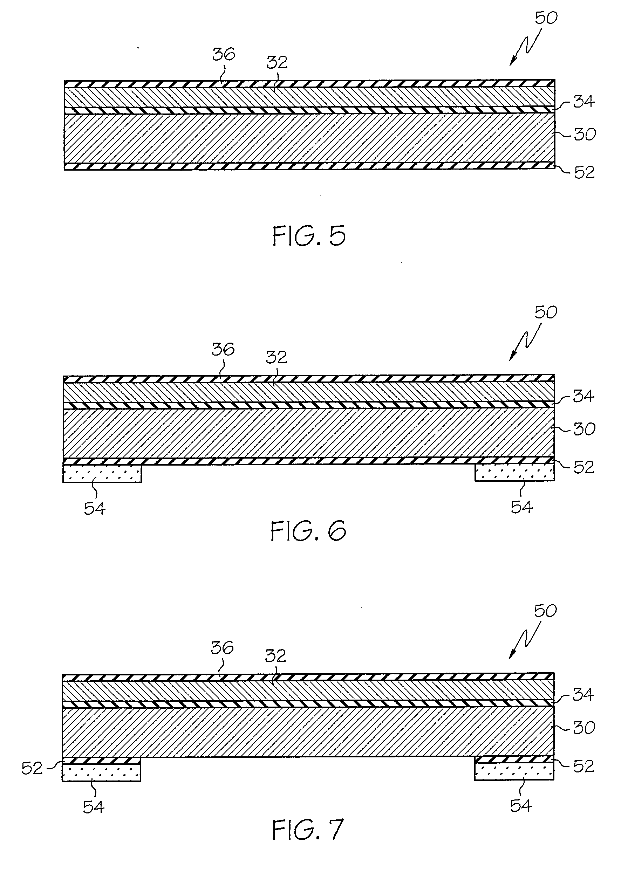

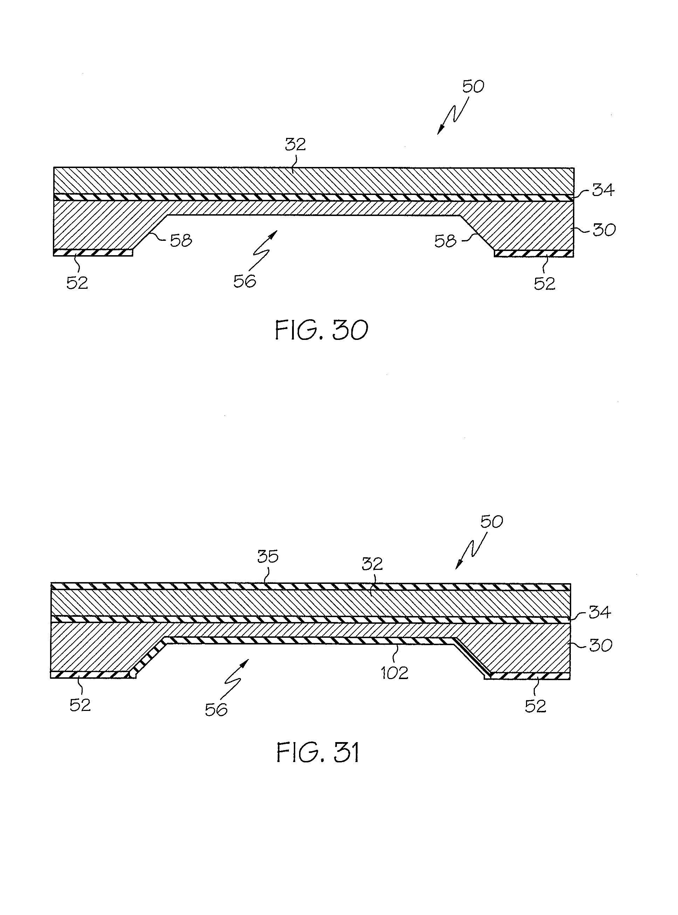

One process for forming the probe finger structure 16 of Fig. 3 is shown in Figs. 5-29 and discussed below, although it should be understood that different steps may be used in the process, or an entirely different process may be used without departing from the scope of the invention. Thus, the manufacturing steps illustrated herein are only one manner in which a probe structure 14 may be manufactured, and the order and details of each step described herein may vary or other steps may be used or substituted with the other steps as is well known in the art. A number of probe finger structures 14 may be simultaneously formed on a single wafer in a batch manufacturing process. However, for clarity of illustration, Figs. 5-29 (as well as Figs. 30-47 discussed below) illustrate only a single probe finger structure 14 being formed.

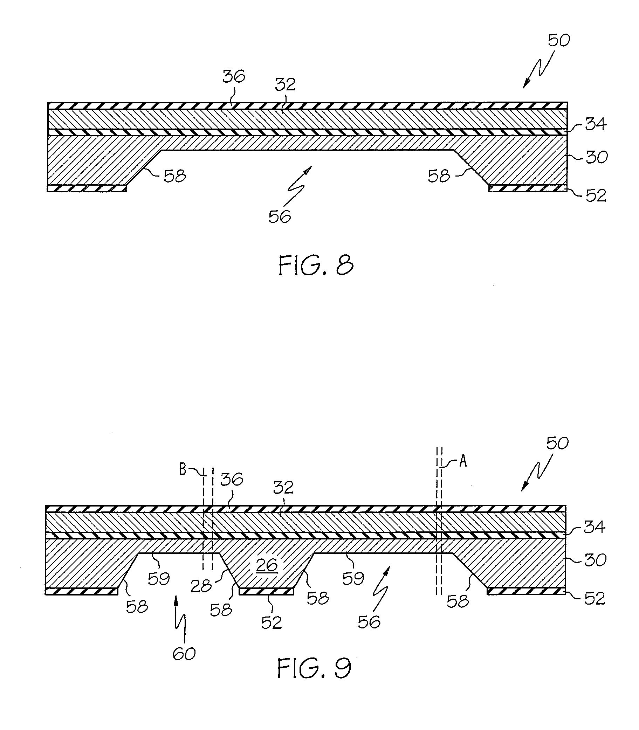

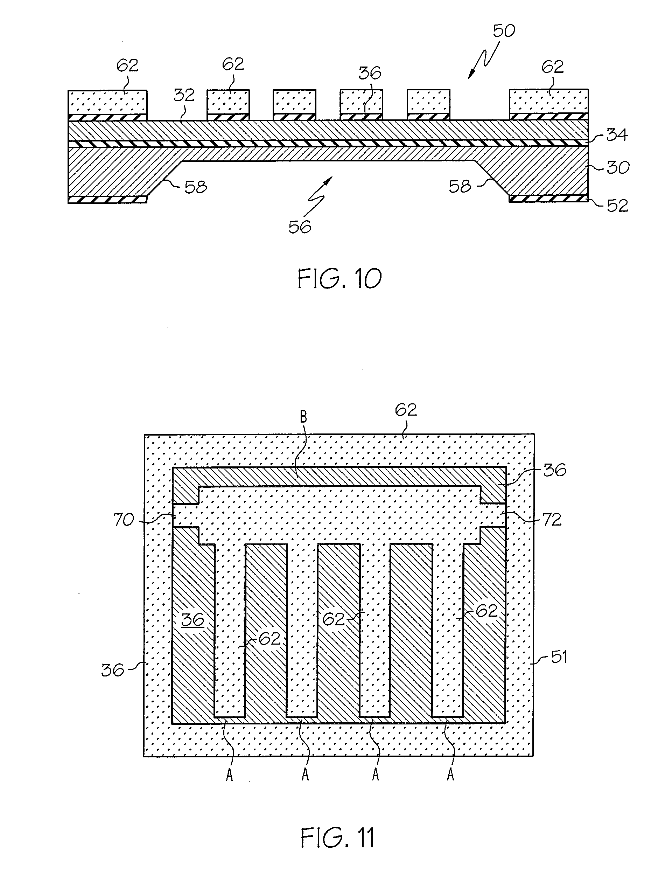

The majority of Figs. 5-29 are lateral cross sections taken along, for example, the ends of the probe fingers 16 (see line 5-5 of Fig. 2). However, Fig. 9 is a longitudinal cross section taken along the length of a probe finger 16 during manufacturing, and Figs. 11, 13, 15, 17, 20, 22, 24, 26 and 29 are top views of the probe structure 14 of various stages of manufacture.

As shown in Fig. 5, the process may begin with a semiconductor-on-insulator wafer 50 such as a silicon-on-insulator (SOI) N-type, double-sided polished wafer. The wafer 50 may include the upper or active (silicon) layer 32, the lower (silicon) layer 30 and the intermediate insulating or etch stop layer 34 (such as silicon dioxide) located therebetween. The upper 32 and lower 30 layers may be either undoped or very low doped single crystal silicon such that the layers 30, 32 have high electrical resistance (i.e. in one case a resistivity of about 800-1200 Ohms-cm). However, the wafer 50 (i.e., the upper 32 and lower 30 layers) may also be made from a variety of materials besides single crystal silicon, including but not limited to amorphous silicon, polysilicon, silicon carbide, germanium, polyimid, ceramic materials, nitride, sapphire, gallium arsenide, gallium nitride, glasses, a combination of materials and any other machinable, preferably electrically resistive, material.

The thicknesses of the upper 32 and lower 30 layers can be selected to provide an end product (probe structure 14) with the desired thickness. For example, the thickness of the upper layer 32 will contribute to the thickness of the lower portion of the probe fingers 16, and the thickness of the lower layer 32 will contribute to the thickness of the base 26. In one embodiment, the upper layer 32 may have a thickness of between about 10 and about 100 microns (in one case, about 35 microns), the intermediate insulating layer 34 may have a thickness of between about 0.1 and about 10 microns (in one case, about 1 micron), and the lower layer 30 may have a thickness of between about 50 and about 1,000 microns (in one case, about 300 microns).

The wafer 50 may include an upper insulating layer 36 such as silicon nitride (i.e., in one case about 1500 angstroms thick) located on the upper surface of the wafer 50 and a lower insulating layer 52, such as silicon nitride, located on the lower surface of the wafer 50. The upper 36 and lower 52 insulating layers can be located on the wafer 50 by any desired method, such as low-pressure chemical vapor deposition ("LPCVD"). Although an oxide may be used instead of the silicon nitride 36, 52, silicon nitride may be preferred due to its resistance to etching in subsequent processing steps.

As shown in Fig. 6, a photoresist 54 may be located on the lower surface of the wafer 50 and patterned to expose the central portion of the insulating layer 52. Next, as shown in Fig. 7, the exposed portions of the lower insulating layer 52 are removed, such as by a plasma etch or any other acceptable process. The photoresist 54 is then removed.

The lower layer 30 is then etched to form cavities 56 (Fig. 8) and 60 (Fig. 9) in the wafer 50 (it should be understood that by "etching" a wafer or wafer portion it is meant to remove portions of the wafer or wafer portion, or to "pattern" the wafer or wafer portion). As shown in Fig. 2, the cavity 56 formed during this step provides a space that will ultimately be located below the suspended probe fingers 16. Fig. 9, which is a cross section taken along the length of a probe finger 16, illustrates that the rear cavity 60 is located behind the portion of the wafer 50 which will ultimately form the base 26. In this manner, the cavity 56 and rear cavity 60 define the side walls of the structure that will ultimately be the base 26. The etching of the lower layer 30 during this step is preferably an anisotropic etch step which creates the angled or tapered surfaces 58 along the (111) crystal plane of the silicon lower layer 30, one of which ultimately forms the angled surface 28 (see Fig. 9). The etch angle may be between about 35°-55°, or between about 40°-50°, or in one case about 54.7°. The thickness of the remaining portions of the lower layer 32 located above the cavities 50, 56 (i.e. the diaphragm 59) may be, for example, about 60 microns. The diaphragm 59 should be sufficiently thick to provide sufficient stiffness or rigidity to the components located above the diaphragm 59 during subsequent processing steps.

In this manner, the etching steps shown in Figs. 8 and 9 can be used to create the tapered surface 28 of the base 26 such that the probe fingers 16 can extend at an angle relative to the substrate 12, as noted above. Alternately, if angled probe fingers 16 are not desired, the cavity or cavities 56, 60 may be formed by dry and/or anisotropic etching methods such as reactive ion etching ("RIE") or deep reactive ion etching ("DRIE"). For illustrative purposes, cutout lanes **A** and **B** of Fig. 9 illustrate portions of the structure that will be etched away during subsequent processing to release the fingers 16.

As shown in Figs. 10 and 11, a photoresist 62 is next located on the upper surface of the wafer 50 and patterned in the manner shown. The photoresist 62 is patterned primarily in the desired shape of the probe fingers 16, to define the upper portion of cutout lanes **A** and **B**, and to define the tabs 70, 72 and frame 51. The exposed portions of the upper insulating layer 36 are then removed, such as by reactive ion etching ("RIE") or other acceptable etching methods.

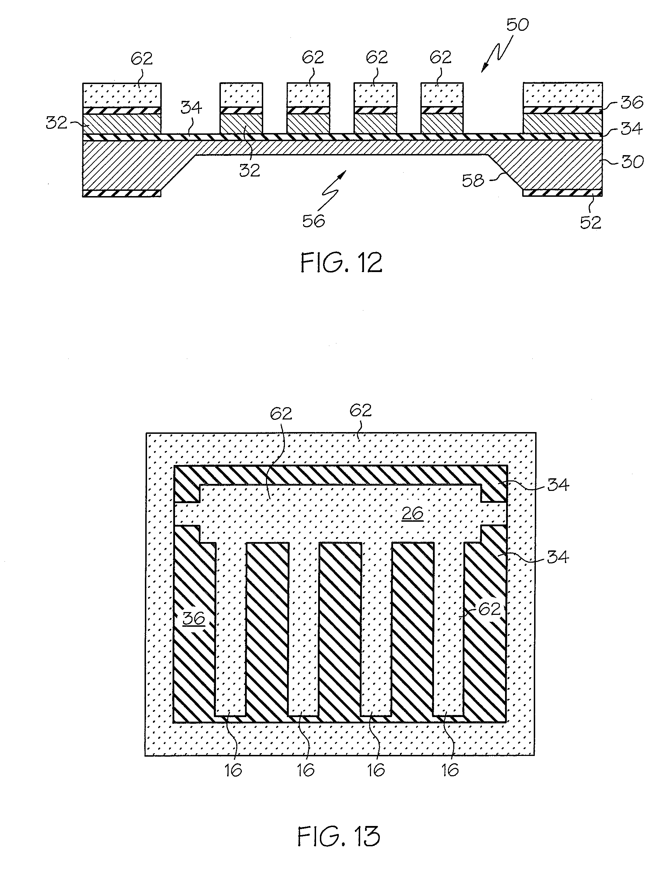

Next, as shown in Figs. 12 and 13, the exposed portions of the upper layer 32 are removed by any acceptable method, such as a dry etch and/or anisotropic etch (i.e. DRIE or plasma etch), a wet etch or other methods. The use of a dry and/or anisotropic etch and/or anisotropic etch to etch the upper layer 32 and to define the fingers 16 may provide generally vertical sidewalls and may allow for better control of the finger width and tighter spacing of the fingers 16. The sidewalls of the fingers may be between about 80-100 degrees, preferably about 90 degrees. The use of a dry and/or anisotropic etch may also limit the etching of the tips of the fingers 16 to provide for more precisely dimensioned fingers.

The upper layer 32 may be etched to the depth of the intermediate insulating layer 34 during this step such that the intermediate insulating layer 34 acts as an etch stop. In this manner, the thickness of the upper silicon layer 32 can be selected to define at least a portion of the height of the probe fingers 16. Thus, the use of a SOI wafer 50 can provide precise etching control and therefore provide control over the height over the silicon or support portion 32 of the probe fingers 16. The precise dimensions of the resultant fingers 16 enables a known force to be applied to the substrate 12 (i.e. in lowering the substrate 12 such that the fingers 16 contact the test component 18) such that all of the fingers 16 consistently and repeatedly make contact with the desired contact location 20.

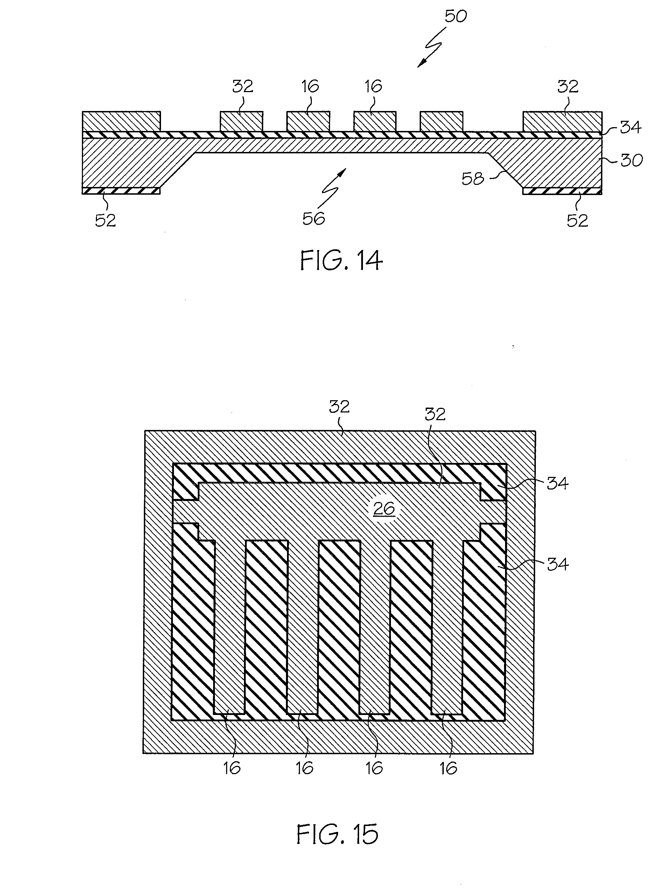

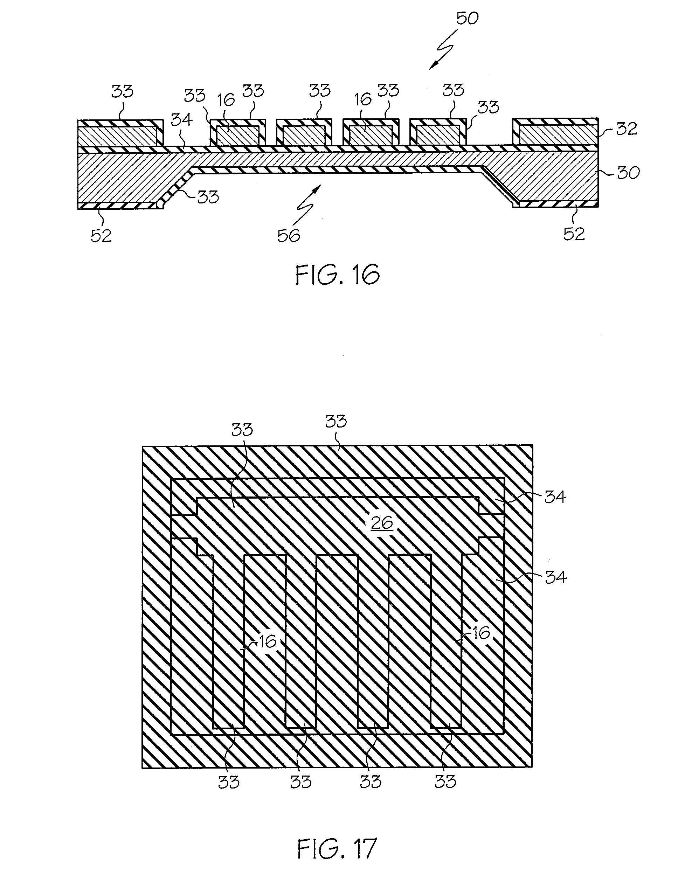

Next, as shown in Figs. 14 and 15, the photoresist 62 is removed, and the remaining portions of the upper insulating layer 36 are removed such as by RIE or any other acceptable method. As shown in Figs. 16 and 17, an insulating layer 33 (such as a 1 micron thick thermal oxide) is then grown or located on all exposed silicon surfaces of the wafer 50, including the fingers 16 and the exposed surfaces of the cavities 56 and 60. The insulating layers surrounding (33) and underlying (34) each probe finger 16 electrically isolates each probe finger 16 from any adjacent probe fingers 16 and protects the bulk (silicon) materials of the fingers 16 during subsequent etching.

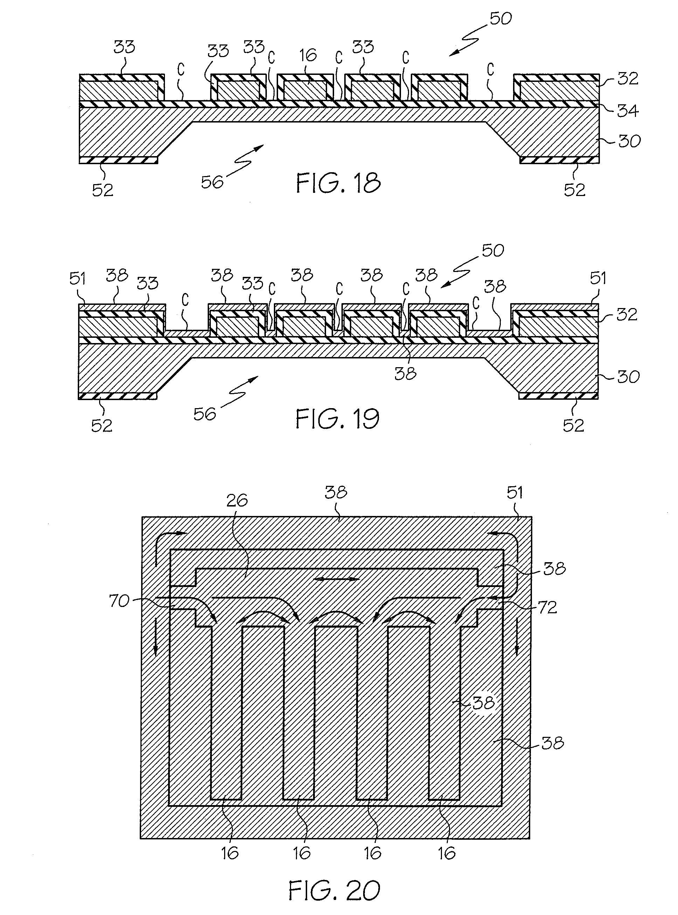

The insulating layer 33 covering the exposed surfaces of the cavities 56, 60 is then removed (Fig. 18). One way to remove the desired portions of the insulating layers 33 is to coat a photoresist on the upper surface of the wafer 50 (to protect the oxides 33, 34 that are not desired to be removed), etch the insulating materials 33 located on the cavities 56, 60 by, for example, RIE, and then removing the photoresist from the front surface of the wafer 50. The desired portions of the insulating layers 33 may also be removed by a buffered oxide etch or other methods.

A seed layer 38 may then be deposited on the upper surface of the wafer 50 by any acceptable method (Figs. 19 and 20). The seed layer 38 aids in the subsequent deposition of the metal or other conductive material 40 on the probe fingers 16. The seed layer 38 may include two or more or less layers, such as titanium located on the oxide layers 33, 34 (for good adhesion to the oxide layers 33, 34 and the wafer 50) and gold located on top of the titanium (to provide a relatively oxide-free surface for subsequent plating processes). However, any of a wide variety of seed metals or materials may be used, including but not limited to NiCr and Cu. The seed material or materials 38 can be located on the wafer 50 by any desired method, such as sputtering to any desired thickness, such as 0.1 micron.

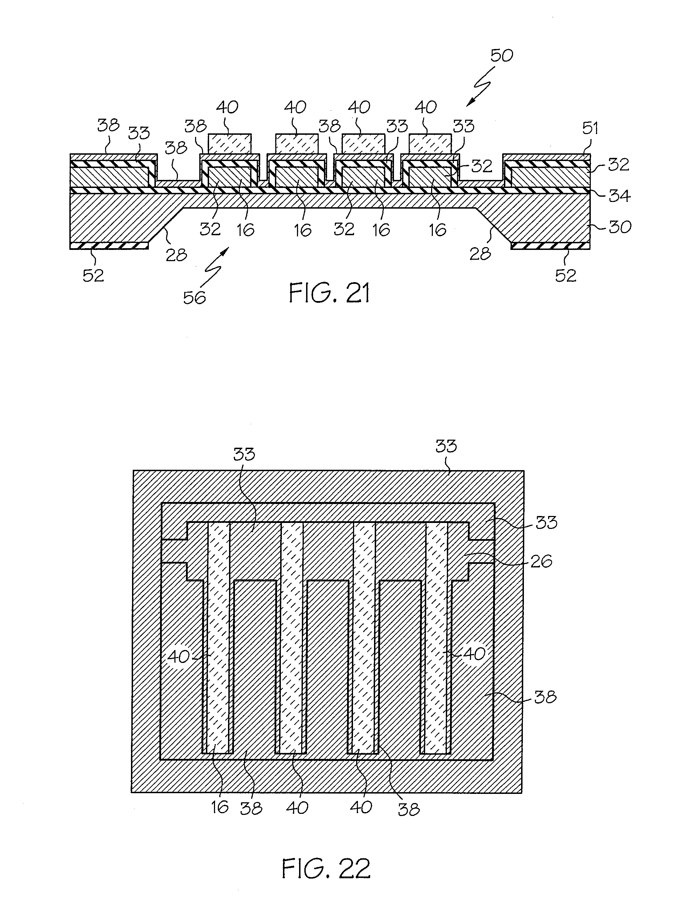

Next, as shown in Figs. 21 and 22, a conductive material 40 (such as nickel, gold, tungsten or nearly any metal or other conductive material) is deposited on top of the seed layers 38 of each of the probe fingers 16 and onto a portion of the base 26. Nickel may be used as the conductive material 40 due to the low film stress of nickel. The conductive material 40 can be located in nearly any desired manner and deposited to nearly any desired thickness. However, in one embodiment, the conductive material 40 is nickel which is electroplated onto the seed layer 38 to a thickness of between about 5-40 microns (in one case, about 18 microns). As can be seen in Figs. 21 and 22, the portions of conductive material 40 may be slightly narrower in width than the associated underlying seed layer 38 and upper layer 32 to accommodate any misalignment in the placement of the conductive material 40 during the electroplating process.

In order to facilitate the electroplating, it may be desired that the seed layers 38 of each probe finger 16 be electrically coupled during the electroplating process. As shown in Figs. 19 and 20, the top surfaces of the tabs 70, 72 frame 51, base 26 and fingers 16 may all be substantially coplanar. In this manner, when the seed layer 38 is deposited on the top surface of the wafer 50, the seed layer 38 is securely deposited on the substantially horizontal, coplanar surface 70, 72, 51, 26 and 16 such that good electrical connections are ensured therebetween. For example current can flow in the direction of the various illustrative short arrows shown in Fig. 20 from the frame 51 to the base 26 and to and between each of the fingers 16.
Furthermore, each probe finger structure 14 on a wafer during batch processing may be electrically coupled such that electrical connection need only be made on one portion of the wafer to apply a voltage to each finger 16 of each probe finger structure 14 during electroplating.

Thus, during the electroplating process or deposition of the conductive material 40, electrical contact can be made anywhere on the frame 51, tabs 70, 72 or base 26 to plate the conductive material 40 on the fingers 16. The structure of this embodiment also does not require sputtering or depositing the seed layer 38 or other conductive material along the vertical side walls of the fingers 16 in order to ensure good electrical contact between the fingers 16. Instead, as noted above, the conducting portions of the seed layer 38 are deposited on the horizontal surfaces of the frame 51, base 26, fingers 16 and tabs 70, 72. The frame 51 or other contact surface may have a surface area comparable to that of the fingers 16 and base 26, such as, about ¼ to about 4 times the surface area of the fingers 16 and/or base 26.

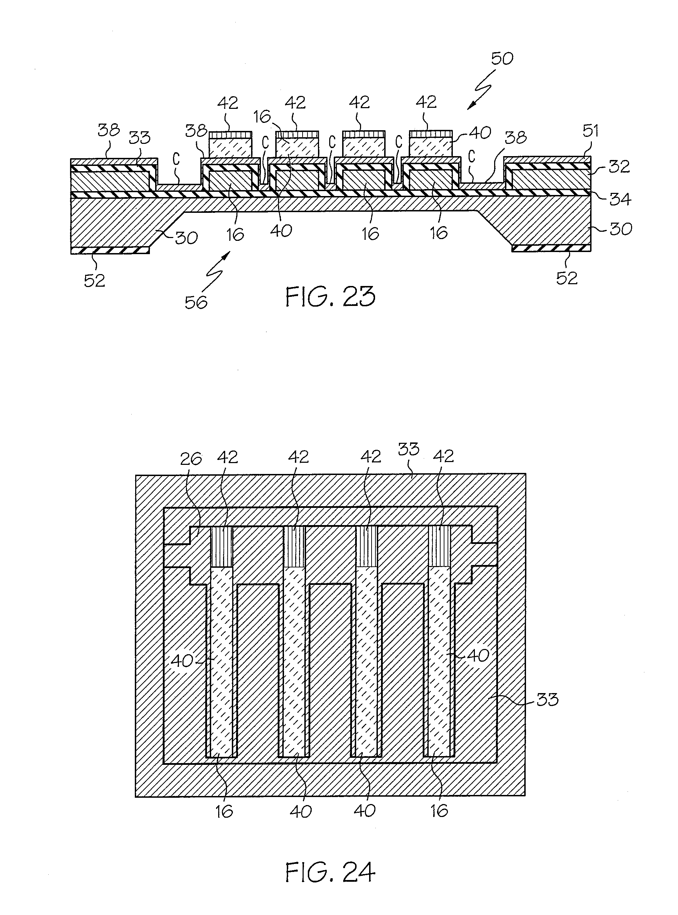

After depositing the conductive material 40, a set of bond pads 42 (such as gold or any desired appropriate bond pad material) may then be deposited at the base of each probe finger 16 on top of the conductive material 40 (Figs. 23 and 24). In one embodiment, the bond pads 42 are made of gold which is electroplated onto the conductive material 40 at a thickness of about 2 microns.

In order to electrically isolate each of the probe fingers, the seed layer 38 located between each of the probe fingers 40 (i.e., at areas **C** of Fig. 23) may be removed. In order to remove the portions of the seed layer 38 located between the fingers 16, a photoresist may be located on the upper surface of the wafer 50, and portions of the photoresist located between the probe fingers 16 (i.e., areas **C**) may be removed by standard exposure and cleaning/stripping steps. Care should be taken to ensure the photoresist between each finger 40 is fully removed. The exposed portions of the seed layer 38 may then be etched away by any variety of desired methods, such as by a wet etch, and the remaining photoresist can then be removed.

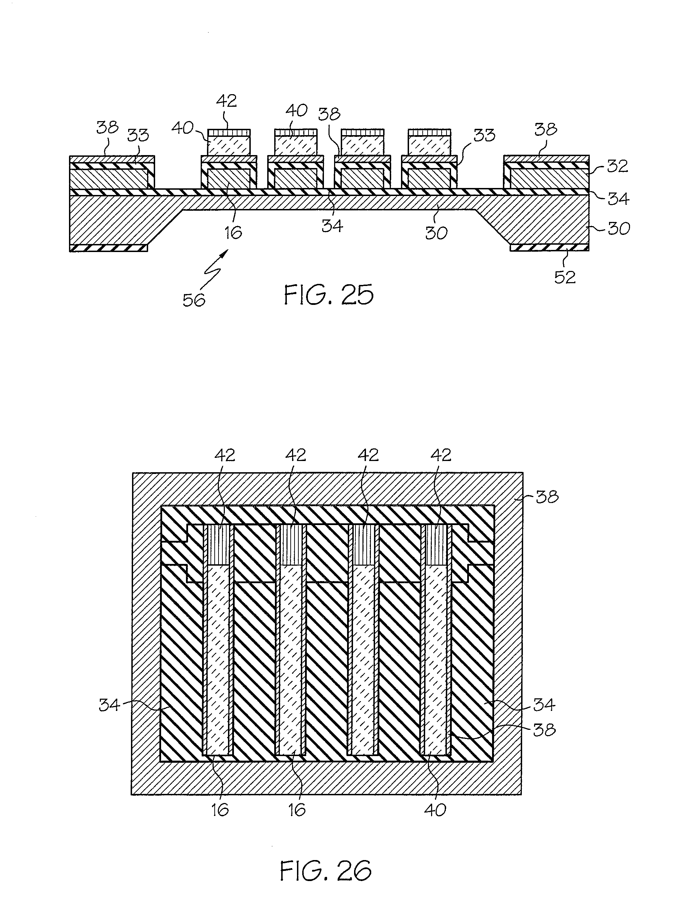

Alternately, rather than using a photoresist and etching to remove the seed layer 38 between the fingers 16, a precisely controlled ion milling may be targeted at each of the areas **C** to remove the seed layer 3 8 located thereon. Under proper control, the ion milling will remove the seed layer 38 and leave the layers below the seed layer 38 essentially undamaged. Figs. 25 and 26 illustrate the wafer 50 after the seed layer 38 located between the fingers 16 has been removed by the desired process.

Alternately, the portions of the seed layer 38 located between the probe fingers 16 can be removed by a "lift-off" process which requires some steps prior to depositing the conductive material 40 on the seed layer 38. For example, prior to depositing the seed layer (i.e. Fig. 18), a photoresist can be deposited on the upper surface of the wafer 50 and patterned such that the photoresist remains only on the portions of the wafer 50 located between the fingers 16 (i.e., at areas **C** at Fig. 18). The seed layer 38 can then be coated on the entire upper surface of the wafer 50, including the photoresist located between the fingers 16 at areas **C**. The wafer 50 can then be placed in a solvent which removes the photoresist and seed layer 38 in the desired areas in a lift-off procedure. The conductive material 40 and bond pads 42 may be located on the seed layer 38.

The lift-off and etching methods for removing the portions of the seed layer 38 may be the preferred method for removing the seed layer 38 because the use of the lift-off and etching methods enables the entire manufacturing process may be carried out in a clean room. Of course, various other methods for removing the desired portions of the seed layer 38 may be used.

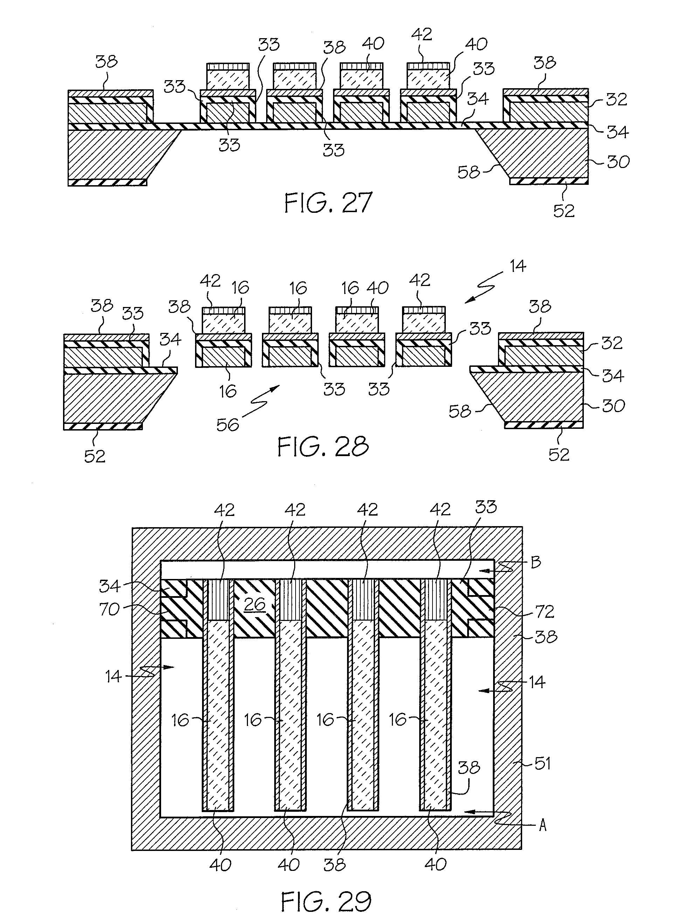

Next, as shown in Fig. 27, the remaining thickness of the lower layer 30 located below the probe fingers 16 and on either side of the base 26 (i.e., the diaphragm 29 above the cavities 56 and 60) is removed by any desired etching method, such as a wet etch using KOH/TMAH. During this step, it may be desired to retain the etching materials below the intermediate insulating layer 34 to prevent the etching material from contact the probe fingers 16 and causing undesired etching of the probe fingers 16. For this reason, it may be desired to perform the majority of the etching of the lower layer 30 earlier during the manufacturing process (i.e., as shown in Figs. 8 and 9). The earlier etching of the lower layer 30 may leave only a small thickness of the lower layer 30 to be removed at this step at the end of the manufacturing process to minimize adverse effects.

Furthermore, the insulating layers 33 which are located completely around and essentially "encapsulate" each probe finger 16 help to ensure that any etching materials that may come into contact with the probe fingers 16 during this etching step are isolated from, and therefore do not etch away, the bulk materials 32 of the probe fingers 16.

It may also be desired to do an early partial etch of the lower layer 30 (i.e., at Figs. 8 and 9) because if the entire lower layer 30 was etched at this stage (i.e., Fig. 27) of manufacturing, the stress from the weight of the top side may cause undesired etch angles, and may therefore lead to undesired angles for the tapered surfaces 28, 58 of the base 26. If desired, anisotropic etching methods, such as a plasma etch or other acceptable methods, may also be used during this step (Fig. 27) to etch the remaining portions of the lower layer 30. The anisotropic etching step of Figs. 8 and 9 may sufficiently define the tapered surfaces 28, 58 of the lower material 30 base 26 such that anisotropic etching at this stage (Fig. 27) is not required.

Finally, as shown in Figs. 28 and 29, the exposed portions of the intermediate insulating layer 34 (i.e., the portions located above the cavities 56, 60) are then removed by any desired method, such as RIE, to release the suspended portions of the probe fingers 16. The probe structure 14 may be cut or diced at tabs 70, 72 (Fig. 29) to release the probe structure 14 from the surrounding frame or wafer structure 51. The probe finger structure 14 can then be coupled to a substrate 12 (Fig. 3), and the resultant testing structure 10 may be shipped to a customer or used in testing apparatus.

Figs. 30-47 illustrate a manufacturing process that may be used to form the probe structure 14 shown in Fig. 2. The initial steps for this manufacturing process are the same as the steps shown in Figs. 5-8 for the manufacturing processes discussed above. That is, an SOI wafer is provided and the lower layer 30 is etched to form the cavity 56. Next, the insulating layer 36 is then removed by any desired method, such as RIE, which results in the wafer 50 shown in Fig. 30 (alternately, a starting wafer without the upper insulating layer 36 may be used). An insulating layer 35, 102, such as a one micron thick thermal oxide, is then deposited or grown on the exposed surfaces of the upper 32 and lower 30 layers, including the surfaces of the cavities 56 and 60 (Fig. 31).

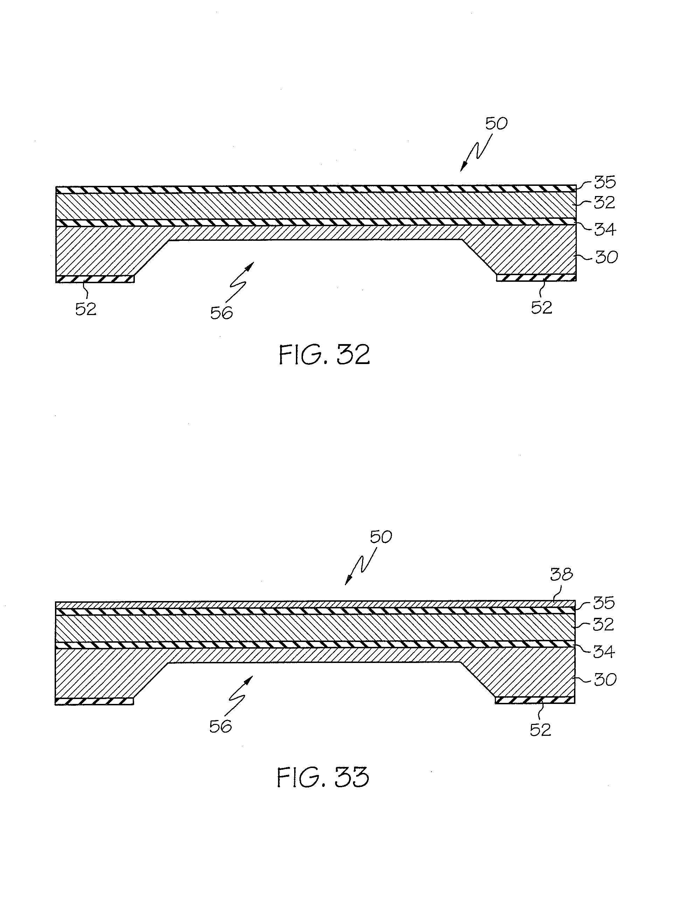

As shown in Fig. 32, the portions of the insulating layer 102 located on the cavities 56 and 60 are then removed. The desired portions of the insulating layer 102 may be removed by any desired method, such as by locating a photoresist on the front surface of the wafer 50, etching the exposed insulating layer 102 on the lower surface of the wafer 50 (such as by a buffered oxide etch ("BOE")) and then removing the photoresist.

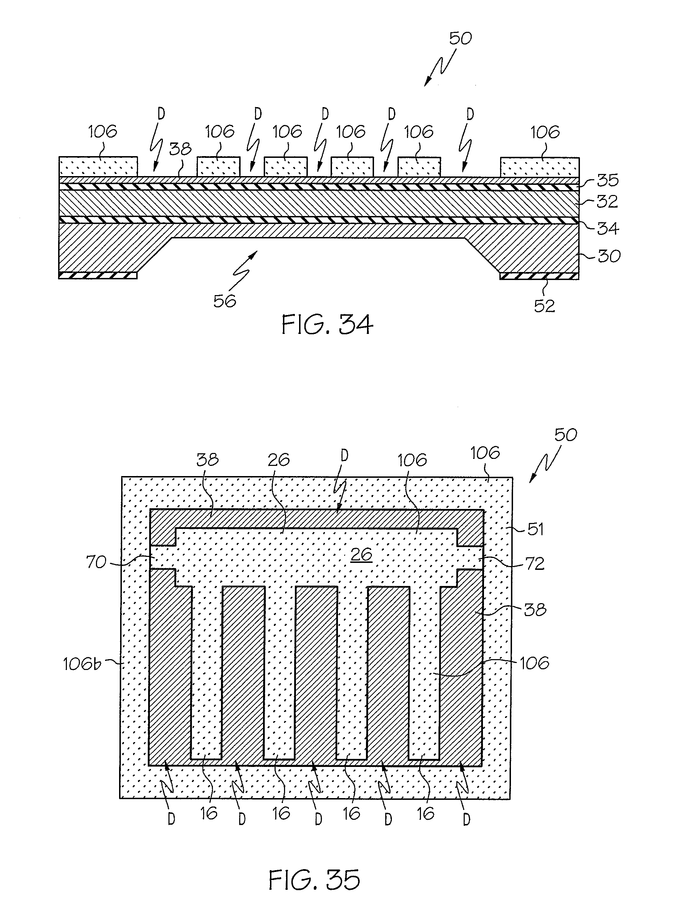

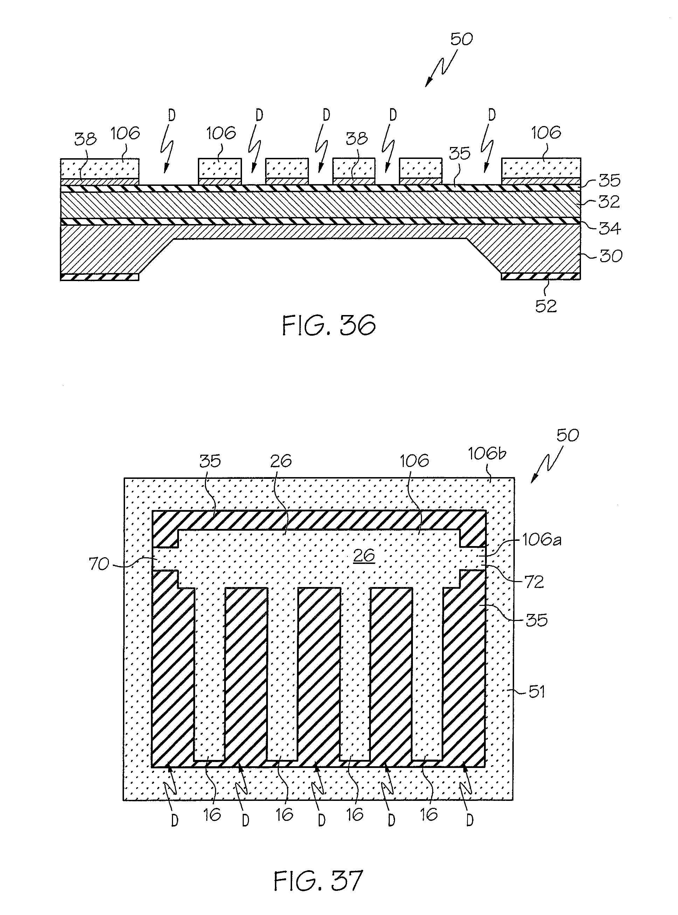

The seed layer 38 may then be located on the upper insulating layer 35 by any desired method, such as sputtering (Fig. 33). A photoresist 106 is then deposited on top of the seed layer 38 (Figs. 34 and 35) and patterned generally in the shape of the probe fingers 16, tabs 70, 72 and frame 51. The portions of the seed layer 38 not covered by the photoresist 106 are then removed or etched away, such as by a wet etch or other acceptable methods (Figs. 36 and 37).

When removing the portions of the seed layer 38 during this step, the portions of the seed layer 38 at areas D between the fingers 16 and spaced away from the base 26 are removed. However, selected portions of the seed layer 38 remain on the top side of the wafer 50 to electrically connect the fingers 16. In particular, although not visible in the top views of Figs. 35 and 37, the seed layer 38 is located below the photoresist 106 such that the fingers 16, base 26, tabs 70, 72 and frame 51 remain electrically connected via the seed layer 38. The electrical connections via the seed layer 38 of each of the fingers 16 enable the fingers 16 to remain electrically coupled to aid in the subsequent electroplating process in the same manner described above. When the seed layer 38 is deposited (Fig. 33) the seed layer 38 is located on a generally planar, horizontal surface to ensure good adhesion of the seed layer 38 to the wafer 50.

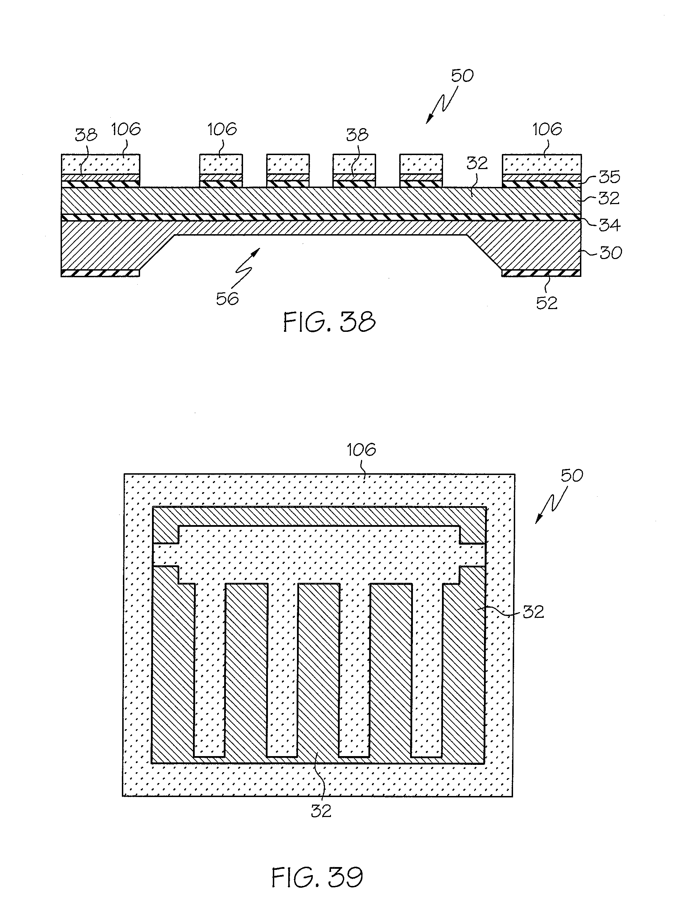

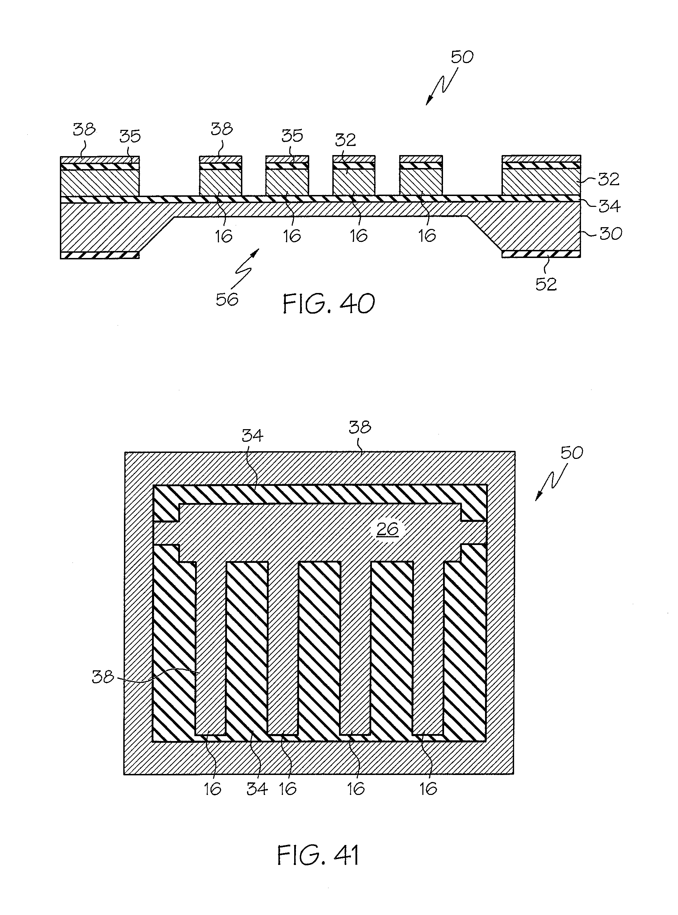

As shown in Figs. 38 and 39, the portions of the insulating layer 35 not covered by the photoresist 106 are then etched or removed such as by a plasma etch or other acceptable methods. Finally, the portions of the upper layer 32 not covered by the photoresist 106 are removed to a depth of the intermediate insulating layer to define the probe fingers 16 (Figs. 40 and 41). The upper layer 32 can be etched by DRIE or other acceptable methods.

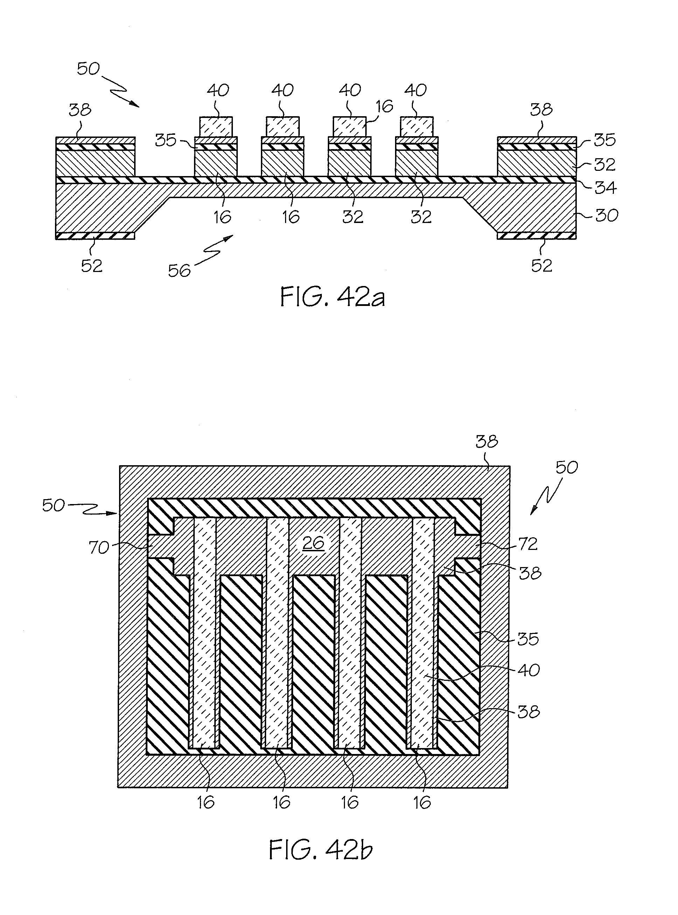

The photoresist 106 is then removed or stripped and the portions of conductive material 40 are then located on the seed layer 38 of the probe fingers 16, such as by electroplating nickel 40 on the seed layer 38 (Figs. 42a and 42b). As noted above, the fingers 16, base 26, tabs 70, 72 and frame 51 are electrically connected via the seed layer 38 to aid in the electroplating process.

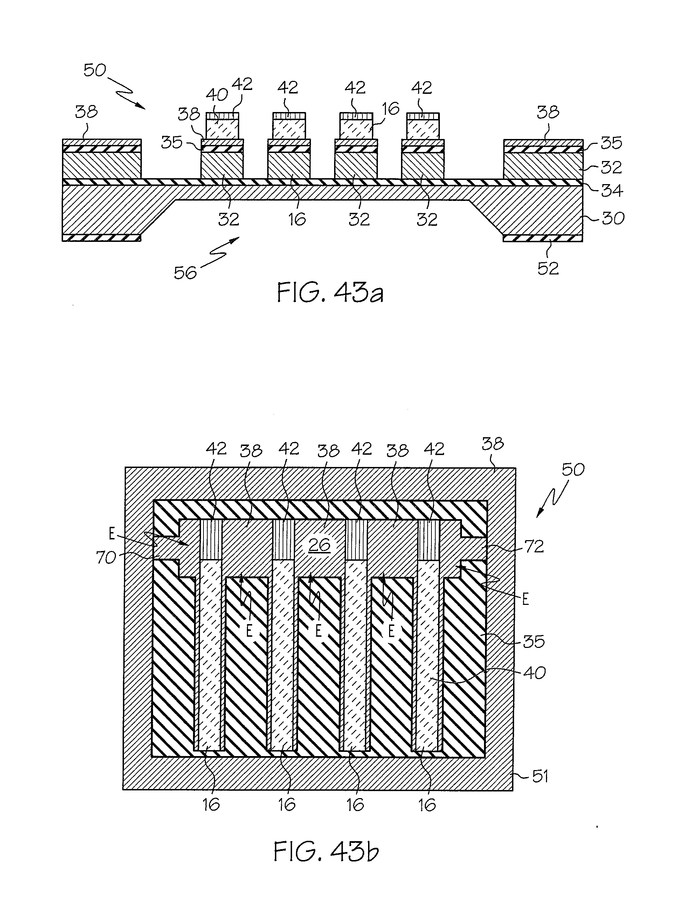

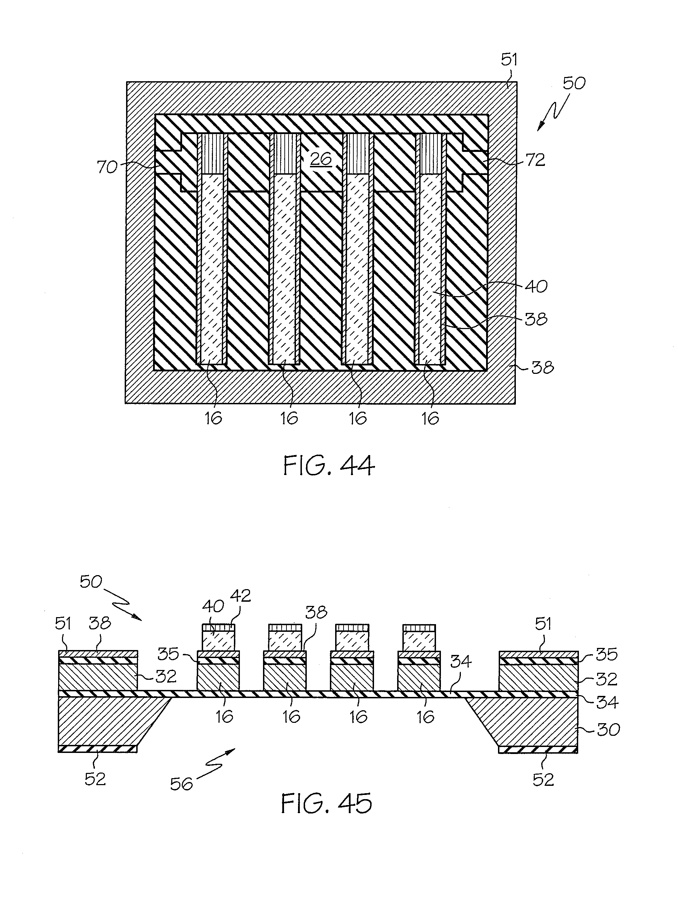

The bond pads 42 are then located at the base of each finger (Figs. 43a and 43b). Next, the portions of the seed layer 38 not located below the conductive material 40 (that is, on or forming part of the fingers 16) are removed, such as using a photoresist and etching the seed layer 38 by a wet etch (Fig. 44). In other words, the portions of the seed layer 38 located between the fingers 16 and on the base 26 (i.e., at area E) are removed to electrically isolate each of the fingers 16.

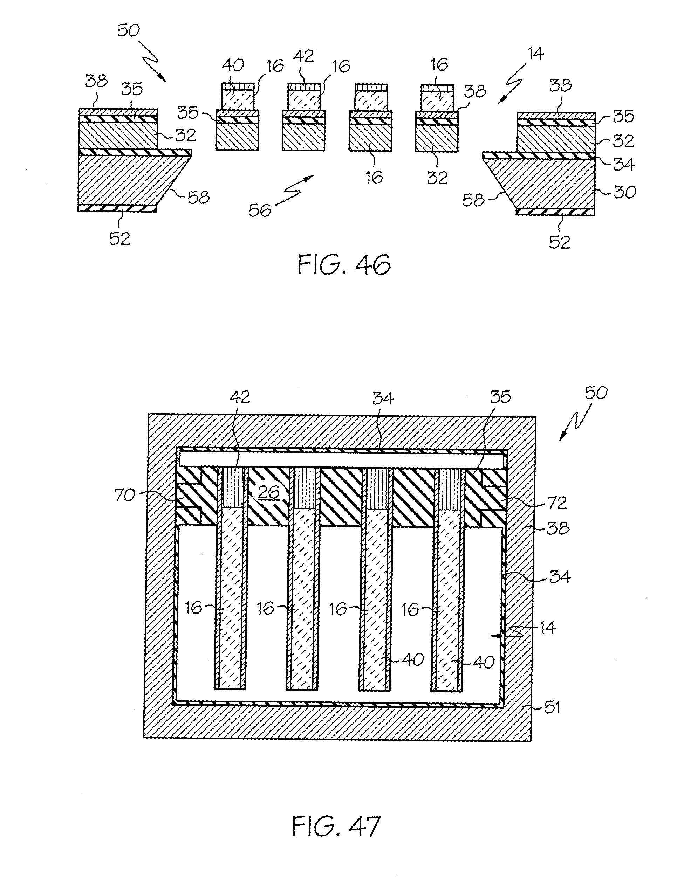

As shown in Fig. 45, the remaining portion of the lower layer 30 located below the probe fingers 16 (i.e., the portions located above the cavities 56 and 60) is then removed (i.e., to a depth of the intermediate insulating layer 34) such as by a wet etch (i.e., KOH/TMAH) or various other etching methods, including anisotropic etching methods. The exposed portions of the intermediate insulating layer 34 are then removed to release the probe fingers (Figs. 46 and 47). Finally, the probe structure 14 may be cut or diced at tabs 70, 72 to release the probe structure 14 from the surrounding wafer structure or frame 51. The probe structure 14 can then be coupled to a substrate 12 and the resulting testing structure 10 may be shipped to a customer or used in a testing apparatus.

The process shown in Figs. 5-30 provides probe fingers 16 having lower layers 32 that are fully covered with an oxide 33 to protect the bulk material 32 of the fingers 16 during the manufacturing process or when exposed to other corrosive environments. This may provide a high degree of control over the final dimensions of the fingers 16. On the other hand, the process shown in Figs. 31-48 is easy to implement due to the fact that the seed layer 38 is easily etched to electrically isolate the fingers 16 (i.e. during the step shown in Fig. 44).

If it is desired to produce the probe finger structure 14 shown in Fig. 4, the portions of the base 26 of the comb structure (i.e., the portions of the upper layer 32) located between the fingers 16 may be etched away during the etching of the upper layer 32 during the appropriate etching sep of the upper layer 32 (i.e., at Figs. 10-13 or Figs. 40 and 41).

Furthermore, the probe finger structure shown and described herein may have various other uses besides use in a contact structure. For example, the probe finger structure 14 or probe structure 14 may be used as part of a chemical sensor, electrical sensor, inertial sensor, DNA screening device, microactuator, atomic force microscope ("AFM"), scanning probe microscope ("SPM") and the like.

Having described the invention in detail and by reference to the preferred embodiments, it will be apparent that modifications and variations thereof are possible without departing from the scope of the invention.

## Claims

1. A method for making a probe finger structure comprising the steps of:
providing a wafer or wafer portion having an upper layer, a lower layer and a generally electrically insulating layer or etch stop layer located between said upper and lower layers;
etching said lower layer to form a mounting portion;
etching said upper layer to form a plurality of probe fingers; and
locating an electrically conductive material on each of said probe fingers.

2. The method of claim 1 wherein said etching of said upper layer occurs after said etching of said lower layer.

3. The method of claim 1 further comprising the step of, after said second etching step, removing portions of said lower layer located below said plurality of probe fingers such that said probe fingers are generally suspended over a cavity.

4. The method of claim 1 wherein said wafer or wafer portion is a silicon-on-insulator wafer or a portion of a silicon-on-insulator wafer.

5. The method of claim 1 wherein said first etching step includes etching at least part of said lower layer to a depth of said insulating or etch stop layer, and wherein said second etching step includes etching at least part of said upper layer to a depth of said insulating or etch stop layer.

6. The method of claim 1 wherein said first etching step includes anisotropic etching.

7. The method of claim 1 wherein said second etching step includes dry etching.

8. The method of claim 1 said second etching step includes forming a base structure in said first layer, and wherein each probe finger extends outwardly from said base to form a generally comb-like structure.

9. The method of claim 1 wherein said upper and lower layers are each a semiconducting material.

10. The method of claim 1 wherein said first etching step includes etching a cavity, and wherein said second etching step includes forming said plurality of probe fingers over said cavity.

11. The method of claim 1 further comprising the step of etching said away portions of said upper layer located below each finger to a depth of said insulating or etch stop layer.

12. The method of claim 1 wherein said wafer or wafer portion includes an upper insulating portion located on said upper layer and a lower insulating portion located on said lower layer, and wherein the method includes the step of removing at least part of said lower insulating portion before said first etching step, and wherein said first etching step includes etching said lower layer to a depth less than the thickness of said lower layer to form a cavity under the area in which said probe finger will be formed.

13. The method of claim 12 further comprising the step of, after said first etching step, patterning said upper insulating portion generally in the shape of said plurality of probe fingers.

14. The method of claim 13 further comprising the step of, after said second etching step, locating a finger insulating layer on said plurality of probe fingers.

15. The method of claim 14 wherein said finger insulating layer generally covers any exposed surfaces of each probe finger.

16. The method of claim 15 further comprising the step of locating a seed layer on each probe finger and wherein said electrically conductive material is located on said seed layer.

17. The method of claim 16 further comprising the step of locating a bond pad on each probe finger and removing portions of said seed layer located between each probe finger.

18. The method of claim 17 further comprising the step of removing portions of said lower layer and said lower insulating layer located below each finger such that said fingers are generally suspended.

19. The method of claim 1 wherein said upper layer includes an upper insulating layer thereon, and wherein the method further includes the step of locating a seed layer on top of said upper insulating layer.

20. The method of claim 19 further comprising the step of patterning said seed layer in the shape of a plurality of probe fingers.

21. The method of claim 20 further comprising the step of removing the portions of said seed layer, the portions of said upper insulating layer and the portions of said upper layer that are located between each probe finger, and wherein said electrically conductive material is deposited on portions of said seed layer.

22. The method of claim 21 further comprising the step of, after said locating step, locating a bond pad on each probe finger.

23. The method of claim 22 further comprising the step of removing portions of said lower layer and said lower insulating layer located below each finger such that said fingers are generally suspended.

24. The method of claim 1 wherein said method is a batch process such that at least two probe finger structures are formed on said wafer or wafer portion, and wherein said second etching step includes etching said upper layer to form a frame which is generally coplanar with said probe fingers of both of said probe finger structures.

25. The method of claim 24 wherein said frame is contiguous with said probe fingers of both of said probe finger structures.

26. The method of claim 25 further comprising the step of, prior to locating said conductive material, locating a generally conductive seed layer on an upper surface of said frame and an upper surface of both said probe finger structures such that said frame and both probe finger structures are generally electrically coupled.

27. The method of claim 1 wherein at least one of said first or second etching steps includes etching said wafer to form a frame located adjacent to said mounting portion and probe fingers, said frame having an upper surface that is generally coplanar with an upper surface of said mounting portion and probe fingers.

28. The method of claim 27 wherein said frame is a generally closed shape located around said probe fingers.

29. The method of claim 27 further comprising the step of, prior to locating said conductive material, locating a generally conductive seed layer on an upper surface of said frame and an upper surface of said probe finger structure such that said frame and said probe finger structures are generally electrically coupled.

30. The method of claim 29 further comprising the step of, after locating said conductive material, removing portions of said seed layer such that each probe finger is electrically isolated from any adjacent probe finger.

31. The method of claim 1 wherein said second etching step includes forming probe fingers with generally vertical side walls.

32. A probe finger structure formed by the steps of:
providing a wafer or wafer portion having an upper layer, a lower layer, and a generally electrically insulating layer or etch stop layer located between said upper and lower layers;
etching said lower layer to form a mounting portion;
etching said upper layer to form a plurality of probe fingers; and
locating an electrically conductive material on each of said probe fingers.

33. A method for making a probe finger structure comprising the steps of:
providing a wafer or wafer portion having an upper layer, a lower layer of material and a generally electrically insulating layer or etch stop layer located between said upper and lower layers;
etching said lower layer to a depth less than the thickness of said lower layer to form a cavity;
etching said upper layer to form a plurality of probe fingers having generally vertical side walls; and
locating an electrically conductive material on each of said probe fingers.

34. The method of claim 33 wherein said plurality of probe finger formed during said second etching step are located above said cavity.

35. The method of claim 33 further comprising the step of etching said away portions of said lower layer located below each finger to a depth of said insulating or etch stop layer.

36. The method of claim 33 wherein said second etching step is a dry etching step.

37. A probe finger structure comprising:
a base including an upper layer, a lower layer and a generally electrically insulating layer or etch stop layer located between said upper and lower layers; and
a plurality of generally electrically conductive probe fingers extending generally outwardly from said base.

38. The structure of claim 37 wherein each probe finger includes a support portion which is made from the same material as said upper layer, and a conductive portion located thereon.

39. The structure of claim 38 wherein said support portion of each finger is generally coplanar with said upper layer and has about the same thickness as said upper layer.

40. The structure of claim 38 further including a seed layer located between each support portion and the associated conductive portion.

41. The structure of claim 37 wherein said upper layer and said lower layer include at least one material selected from the group consisting of single crystal silicon, amorphous silicon, polysilicon, silicon carbide, germanium, polyimid, ceramic materials, nitride, sapphire, gallium arsenide, gallium nitride and glasses.

42. The structure of claim 37 wherein each of said upper and lower layers are silicon, and said insulating or etch stop layer is silicon dioxide.

43. The structure of claim 37 wherein said base and said probe fingers form a generally comb-shaped structure.

44. The structure of claim 37 wherein each finger includes a support portion with a conductive portion located thereon, and wherein each support portion is generally encapsulated in a generally electrically insulating material.

45. The structure of claim 37 wherein each finger includes a bonding pad located at a base of each finger.

46. The structure of claim 37 wherein each finger is generally electrically isolated from any adjacent fingers.

47. The structure of claim 37 wherein there are no portions of said upper layer located between each finger in a generally lateral direction.

48. The structure of claim 37 wherein each finger is generally cantilevered.

49. The structure of claim 37 wherein each finger has generally vertical sidewalls.

50. The structure of claim 37 wherein said base is coupled to a wafer, and wherein said wafer includes a support that is generally coplanar with said base, and wherein said wafer includes a supplemental base and plurality of supplemental probe fingers extending generally outwardly from said supplemental base, said wherein said supplemental base is generally coplanar with and coupled to said support.

51. The structure of claim 50 wherein said support is contiguous with said base and said supplemental base such that a conductive material can be located on said support, said base and said supplemental base to electrically couple said base and said supplemental base.
